(19) **Europäisches Patentamt / European Patent Office / Office européen des brevets**

(11) **EP 1 797 821 A1**

(12) **EUROPEAN PATENT APPLICATION**
published in accordance with Art. 158(3) EPC

(43) Date of publication:
**20.06.2007 Bulletin 2007/25**

(21) Application number: **05793167.7**

(22) Date of filing: **12.10.2005**

(51) Int Cl.:
**A61B 5/055** (2006.01)

(86) International application number:
**PCT/JP2005/018822**

(87) International publication number:
**WO 2006/051665 (18.05.2006 Gazette 2006/20)**

(84) Designated Contracting States:
**DE NL**

(30) Priority: **10.11.2004 JP 2004326640**

(71) Applicants:
• **KABUSHIKI KAISHA TOSHIBA**
  **Tokyo 105-8001 (JP)**
• **Toshiba Medical Systems Corporation**
  **Otawara-shi,**
  **Tochigi-ken 324-8550 (JP)**

(72) Inventors:
• **IKEDO, Masato**
  **Int. Prop. Division**
  **Otawara-shi, Toichigi 324-8550 (JP)**
• **YUI, Masao**
  **Int. Prop. Division**
  **Otawara-shi, Toichigi 324-8550 (JP)**

(74) Representative: **Kramer - Barske - Schmidtchen**
  **Radeckestrasse 43**
  **81245 München (DE)**

(54) **PHASE FOLD-BACK DEVELOPMENT METHOD AND MAGNETIC RESONANCE IMAGING DEVICE USING THE METHOD**

(57) In a phase unwrapping evolution method according to the invention, steps of grouping phase data first (S1), phase unwrapping evolution targeting groups is performed (S2), and, then, merging of the target groups is performed (S3) are repeatedly applied. As unwrapping evolution processing proceeds, groups increase and information on a phase difference among the group increases. Thus, the influence of phase data that tends to be a cause of failure of unwrapping evolution gradually decreases and a result with higher robustness than the conventional method is obtained. In addition, a group once subjected to unwrapping evolution continues to be subjected to unwrapping evolution as a new group created by merging. Thus, even if a phase is decided once, the group is subjected to wrapping evolution many times in order to match the phase with phases of other groups. As a result, it is possible to prevent a series of occurrence of failure of unwrapping evolution. Failure of unwrapping evolution is reduced compared with the conventional method and stability of unwrapping evolution is improved.

## FIG. 2

START → GROUPING OF PIXELS (S1) → PHASE UNWRAPPING EVOLUTION APPLIED TO GROUPS (S2) → MERGER OF GROUPS (S3) → ENDING CONDITION IS SATISFIED? (S4) — NO (loop back) / YES → END

EP 1 797 821 A1

**Description**

Technical Field

The present invention relates a phase unwrapping evolution method of subjecting phases of plural phase data to unwrapping evolution to be in a range of $2\pi$, respectively, to decide a phase and relates to, for example, a technique that is applied at the time of creation of a phase map in data processing in an MRI (Magnetic Resonance Imaging) apparatus.

Background Art

As it is well known, in an MRI apparatus, in order to perform shimming processing for correcting a non-uniform component of a magnetic field, a phase map representing a distribution of fluctuation amounts of phases due to non-uniformity of the magnetic field is created. In this case, it is necessary to perform phase unwrapping evolution for calculating a true value $\phi+2n\pi$ (n: integer) of a phase $\phi$ calculated by unwrapping a phase in a range of $2\pi$.

As a conventional example of the phase unwrapping evolution, first, there is a method described in a literature "Radiology 1994; 192:555-561". The method described in the literature is a method of repeating steps of deciding a phase of phase data at certain one point, referring to the phase of the phase data decided after that, and applying unwrapping evolution to any one of phase data for which a value is not decided yet to decide a phase. In other words, this method is characterized by performing, on the premise that a phase change is not steep between phase data in the neighborhood, estimation of a true phase of undecided phase data present near data for which a phase is decided.

However, actually, data having a steep phase change compared with data around the data such as phase data located at a boundary of tissues or phase data including noise may be present. When such phase data is processed according to the method described above, since the phase unwrapping evolution is performed with reference to decided data in the neighborhood, it is highly likely that a true phase is miss-estimated. In addition, since processing is advanced assuming that a phase of decided phase data is correct, if unwrapping evolution fails once to decide a phase while the true phase remains miss-estimated, miss-estimation of a true value occurs in series in the following unwrapping evolution that refers to the miss-estimated phase data.

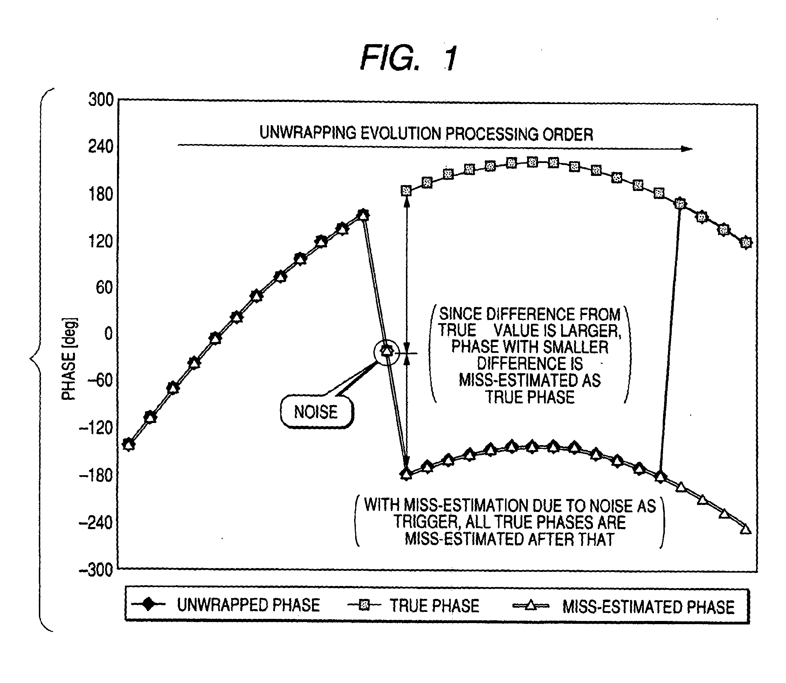

FIG. 1 shows an example in which unwrapping evolution fails because of an influence of noise in the conventional phase unwrapping evolution method when data having a steep phase change compared with data around the data such as phase data located at a boundary of tissues or phase data including noise is present.

As it is evident from this example, in the conventional method, since the phase unwrapping evolution is applied to phase data with reference to decided data in the neighborhood, it is highly likely that a true phase is miss-estimated. In addition, since processing is advanced assuming that a decided phase of phase data is correct, if unwrapping evolution fails once and a phase is decided while the true phase remains miss-estimated, miss-estimation of a true value occurs in series in the following unwrapping evolution that refers to the miss-estimated phase data. In this way, in the conventional method, since the phase unwrapping evolution is sequentially performed in order to match phases among respective data, there is a problem in that failure of the phase unwrapping evolution occurs in a wide range when there is only one data having a steep phase change compared with data around the data described above.

Thus, in order to finally reduce an influence exerted by such data, a method of performing phase unwrapping evolution between fragmented areas to match phases among plural phase data rather than applying phase unwrapping evolution to the data one by one is proposed in JP-A-2002-306445.

However, the method described in the literature is on the premise that the phase unwrapping evolution is performed in the respective areas before performing the phase unwrapping evolution among the areas and there is no reference to how unwrapping evolution inside the area is performed. Consequently, it is surmised that problems same as those in the method of the sequential phase unwrapping evolution described above are not solved and still present in the inside of the respective areas.

Disclosure of Invention

It is an object of the invention to provide a phase unwrapping evolution method that can suppress an influence of phase data, a true value of which tends to be miss-estimated, and perform robust and highly stable phase unwrapping evolution and a magnetic resonance imaging apparatus that can create an ideal phase map using the method and appropriately correct a non-uniform component of a magnetic field.

A phase unwrapping evolution method according to the invention is a phase unwrapping evolution method of subjecting phases of plural phase data in a target area to unwrapping evolution, respectively, to decide a phase, the phase unwrapping evolution method including: a first step of grouping the phase data under a predetermined condition; and a second step of matching phases among at least two groups grouped in the first step, wherein, in the second step, phases of all phase data in an arbitrary group subjected to the grouping are shifted by a predetermined amount and subjected to unwrapping evolution by a unit of group and, then, phases are matched between the group and the other groups.

A magnetic resonance imaging apparatus according to the invention is an apparatus that performs shimming processing with an object of correcting a non-uniform component of a magnetic field, the magnetic resonance imaging apparatus including: grouping means that groups phase data of a phase map representing a distribution of fluctuation amounts of phases due to non-uniformity of the magnetic field under a predetermined condition; and phase matching means that matches phases among at least two groups grouped by the grouping means, wherein the phase matching means shifts phases of all phase data in an arbitrary group subjected to the grouping by a predetermined amount and performs unwrapping evolution by a unit of group and, then, matches phases between the group and the other groups.

Brief Description of Drawings

FIG. 1 is a waveform chart showing, as an example to which a phase unwrapping evolution method according to the invention is applied, a case in which unwrapping evolution fails because of an influence of noise in the conventional phase unwrapping evolution method when data having a steep phase change compared with data around the data is present.

FIG. 2 is a flowchart showing a flow of a procedure in an embodiment of a phase unwrapping evolution method according to the invention.

FIG. 3 is a diagram for explaining one-to-one phase unwrapping evolution processing targeting groups according to the method shown in FIG. 2.

FIG. 4 is a diagram for explaining merger of the groups after subjected to unwrapping evolution in FIG. 3.

FIG. 5 is a diagram for explaining one-to-many unwrapping evolution processing targeting groups according to the method shown in FIG. 2.

FIG. 6 is a diagram for explaining a specific example of the phase unwrapping evolution processing of the invention.

FIG. 7 is a diagram showing a basic constitution of an MRI apparatus according to the embodiment.

FIG. 8 is a diagram for explaining a "spatially different partial area" for calculating a shimming value in the MRI apparatus shown in FIG. 7.

FIG. 9 is a diagram showing a magnetic field distribution of a Y-Z plane orthogonal to slice areas #1 to #3 in the MRI apparatus shown in FIG. 7.

FIG. 10 is a diagram for explaining a method of calculating shimming values of a zero-th order component and a first-order component for each slice area in the MRI apparatus shown in FIG. 7.

FIG. 11 is a diagram showing a state in which offsets are different for each slice area on a pulse sequence in the MRI apparatus shown in FIG. 7.

FIG. 12 is a diagram showing a correspondence relation between a shimming value and a pulse sequence of a slice area in the MRI apparatus shown in FIG. 7.

FIG. 13 is a diagram showing a magnetic field distribution before correction and a correspondence relation between a shimming value of an $X^2+Y^2$ shim coil and a pulse sequence of a partial area in the M-RI apparatus shown in FIG. 7.

Best Mode for Carrying Out the Invention

An embodiment of the invention will be hereinafter explained with reference to the drawings.

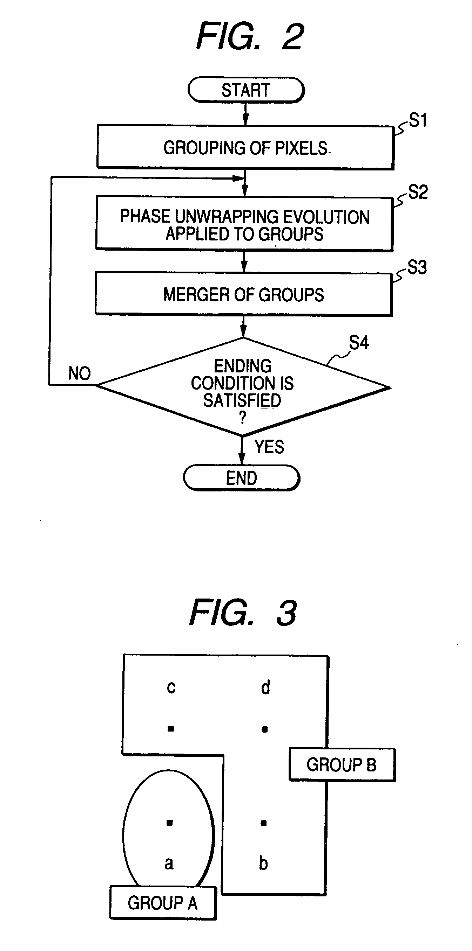

A phase unwrapping evolution method proposed in the invention roughly consists of three steps as shown in FIG. 2. A first step is step S1 of performing grouping of phase data before performing phase unwrapping evolution processing. A second step is step S2 of performing phase unwrapping evolution targeting two or more arbitrary groups among the groups subjected to the grouping in order to match phases among the groups. A third step is step S3 of merging a part or all of the groups subjected to unwrapping evolution.

A processing order of the method will be explained. First, grouping of phase data is performed. Subsequently, steps S1 to S3 of performing the phase unwrapping evolution targeting the groups as described above and, then, performing merging of the target groups are repeatedly applied until an ending condition is satisfied in judgment step S4.

The roughly divided three steps will be explained, respectively.

First, a step of grouping phase data will be explained. Rules in determining whether phase data, a belonging group of which is not determined yet, should be included in a certain group will be explained.

(1) If a phase difference between phase data belonging to a certain group and phase data, a belonging group of which is not determined yet, is within a certain threshold value, the un-belonging data is included in the same group.

If the phase difference exceeds the threshold value, the un-belonging data is included in another group.

(1-1) As a minimum condition, the threshold value is set to a value smaller than 180 [deg] that is generally used as an index indicating that phase unwrapping occurs if a difference between data is larger than the value. As the threshold value is smaller, the grouping is performed more finely. As an example, it is desirable to set the threshold value to 30 to 90 [deg]. However, it is needless to mention that, if the minimum condition described above is satisfied, the threshold value is not limited to this. Belonging-decided phase data, for which a phase difference from un-belonging phase data is calculated, is desirably data located in the neighborhood of the un-belonging data. For example, in two dimensions and three dimensions, data adjacent to the un-belonging data in the four directions or obliquely adjacent to the un-belonging data is set as data for which a difference is calculated.

(1-2) In (1-1) above, a threshold value for determining whether groups are the same is set in advance and data for which a phase difference is calculated is limited to data in the neighborhood of the un-belonging data. An example of grouping different from this is described. As data for which a difference from un-belonging phase data is calculated, data in an arbitrary position not only in the neighborhood such as phase data located in the center of gravity of groups is set as a pair for a phase difference calculation together with the un-belonging phase data. In this case, a threshold value may be fixed to a certain value in the same manner as (1-1) and used. However, it is more effective to use a value weighted according to a distance between both the data as a threshold value. There is also a method not using a phase difference as an index. As an example of the method, it is also possible that an approximate straight line fitted according to a value of a phase is drawn between belonging group data and un-belonging group data and a condition that, if fluctuation in inclination of an approximate formula is equal to or smaller than a certain value before and after including the un-belonging group data at an end of the approximate straight line, the data are included in the same group and, if the fluctuation is not equal to or smaller than the value, the data are included in different groups is adopted.

(2) For grouping of phase data, a belonging group of which is not determined yet, one belonging-decided phase data is associated with the phase data in (1). However, as a method other than (1), a condition that, if a difference between an average value of phase data of a group and a phase of un-belonging phase data is within a certain threshold value, the data are included in the same group and, if the difference is not within the threshold value, the data are included in different groups may be adopted. The threshold value in this case is naturally set to a value smaller than 180 [deg] as in (1). However, it is more desirable to set the threshold value smaller than the threshold value regarded as desirable in (1), for example, set the threshold value to 30 [deg] or less. As the average value of phase data of a group, an average of all phase data belonging to the group may be calculated. Alternatively, an average of phase data of a part of a group may be calculated by, for example, limiting the phase data to data located in the neighborhood of un-belonging phase data.

(3) As another method, if un-belonging phase data is included in a group, a condition that, if fluctuation in phase variance of phase data in the group is within a certain range, for example, 10% before and after the un-belonging phase data, the un-belonging phase data is included in the group may be adopted. In this case, as in (2), a range in which variance is calculated may be set in the entire group or variance may be calculated with phase data of a part of the group by, for example, limiting the phase data to data in the neighborhood of the un-belonging phase data.

As an example of an actual grouping procedure, at first, since there is no phase data, a belonging group of which is determined, the procedure is started by setting phase data in an arbitrary position as a start point and giving a first group ID to the phase data at the start point. Subsequently, concerning un-belonging data adjacent to the start point in the four directions or obliquely adjacent to the phase data in two dimensions and three dimensions, it is determined whether the un-belonging phase data belongs to the same group at the start point using any one of the conditions (1) to (3). Thereafter, grouping of un-belonging phase data adjacent to any one of phase data for which belonging groups are determined in the same manner is performed using any one of the conditions (1) to (3). The work described above is repeated until groups of all the phase data are determined.

Note that, a place where a start point is set and an order of progress of grouping are not specifically designated. For example, phase data in the center may be set as a start point to trace phase data spirally or phase data at an end may be set as a start point to trace phase data in an axial direction row by row. However, an order of performing grouping has to be set to prevent omission of phase data in the grouping.

A condition for grouping may be always fixed to the same condition among the conditions (1) to (3) or may be freely changed in the middle of processing. However, it is desirable to use the condition (1-1) in (1) while the number of phase data belonging to a group is small.

The method of grouping using phases of phase data has been explained. As another example of grouping, for example, the same grouping as described above may be performed on the basis of an absolute value rather than phases of phase data. Besides, as an example of completely different grouping not using information on phase data, phase data may be classified into an arbitrary shape, for example, a rectangular in the case of two dimensions and a rectangular parallelepiped in the case of three dimensions.

In performing grouping of phase data, it is not always necessary to perform the grouping targeting phase data itself obtained first. The grouping may be performed targeting phase data subjected to some processing. As a content of the processing, for example, it is conceivable to perform arbitrary filter processing such as differential filtering or smoothing filtering, perform an arbitrary arithmetic operation, or excluding phase data with small signal value such as a background from phase data in advance according to threshold value processing.

Merging of groups will be explained with reference to an example. First, it is assumed that five groups A, B, C, D, and E are formed according to grouping of phase data. Two or more arbitrary groups, for example, A and B are selected as targets of unwrapping evolution to perform unwrapping evolution in order to match phases between both the groups.

After that, both the groups A and B are merged to form a new group F. At this stage, remaining groups are the four groups C, D, E, and F. In the same manner, unwrapping evolution may be performed targeting two or more arbitrary groups, for example, C, D, and E in order to match phases among the groups to merge the groups. In this case, as the merging of the groups, the three groups C, D, and E may be merged at a time or only a part of the groups such as C and E may be merged.

Assuming that the two groups D and E are merged to form a new group G, groups remaining at this point are C, F, and G. Subsequently, unwrapping evolution is performed targeting the groups C, F, and G and the three groups are merged to form a group H. At this point, a group of phase data is only H. The phase unwrapping evolution processing proposed in this method ends.

Note that, in this example, a condition for ending repetition of unwrapping evolution and merging is that one group is left. However, the condition is not limited to this. The ending condition may be set arbitrarily. For example, the number of times of repetition of unwrapping evolution and merging, the number of groups, the number of boundaries of groups, variance of phases at the time of end of merging, or the like is set as an index. A condition for determining groups selected as targets of the phase unwrapping evolution processing may also be set arbitrarily. As an example of the condition for selecting target groups, priorities are determined according to group IDs (in the example described above, A, B, etc.), the number of belonging phase data, the number of adjacent groups, or the like and a group with a highest priority and groups located in the neighborhood of the group are selected as targets or a combination of all target groups or groups with a minimum phase difference and variance among the groups is selected as a target.

Lastly, the phase unwrapping evolution processing targeting groups and merging of the groups will be explained. In the following description, for simplicity of explanation, it is assumed that there are only four phase data "a" to "d" on a two-dimensional plane as shown in FIG. 3 and the phase data are grouped into two groups as shown in the figure.

The phase unwrapping evolution processing according to this method is performed in accordance with an evaluation value that is calculated on the basis of a phase of a target group. A condition satisfied by the evaluation value calculated on the basis of a phase is not specifically limited. In the following description, phase unwrapping evolution will be explained with reference to several examples of the condition.

(A) An average of phase differences between phase data located in neighborhoods of a boundary of groups is set as an evaluation value. Phases of phase data in the groups are shifted by $2n\pi$ to minimize the evaluation value.

The number of combinations of data for which a phase difference is calculated varies according to how neighborhoods of the boundary are set. However, the number of combinations is not specifically limited either. In FIG. 3, for example, in the case of 4-neighbors in the four directions of the boundary, combinations for calculating a phase difference between the groups A and B are two pairs of "a" and "b" and "a" and "c". In the case of 8-neighbors including oblique directions, combinations for calculating a phase difference between the groups A and B are three pairs with the addition of "a" and "d" to the combinations of the 4-neighbors.

However, even if "n" minimizing an average of phase differences is determined, if one group is shifted by $2n\pi+C$ (C is arbitrary) and the other group is shifted by C, a shift amount minimizing the average of phase differences has values equivalent to infinite combinations depending on a way of setting C. Thus, it is assumed that the shift amount is C=0, that is, phase shift of one group is not performed. A sign of "n" is different and a value of "n" changes depending on which of the groups A and B is subjected to phase shift. Therefore, a group for which a phase is shifted only has to be determined in accordance with, for example, a level of a priority of the group described in the explanation of merging.

In the following description, the explanation is continued assuming that a phase of phase data of the group B is shifted to minimize an average phase difference from A and combinations for calculating a phase difference are set to the 4-neighbors.

When a phase of phase data p is $\phi p$, an evaluation value $\alpha_{BA}$ between the groups B and A is represented as follows.

$$\alpha_{BA}=((\phi b-\phi a)+(\phi c-\phi a))/2$$

In this case, "n" is calculated according to the following expression.

$$n=-int((int(\alpha_{BA}/\pi)+sign(\alpha_{BA}))/2) \qquad (1)$$

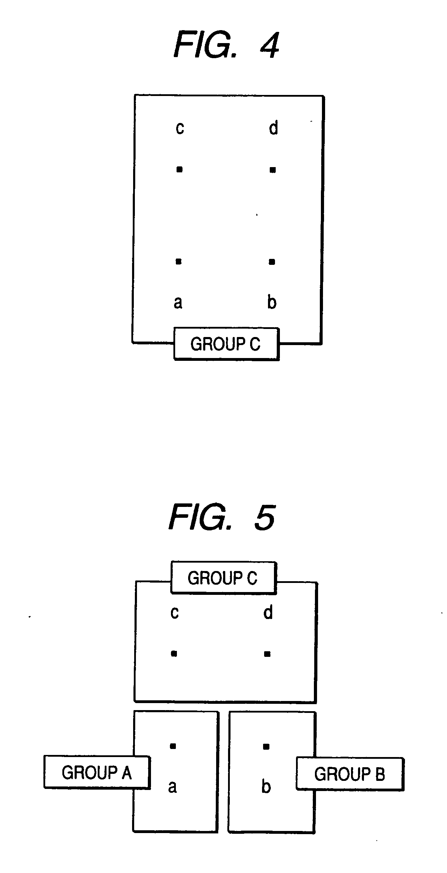

Note that int(x) means an integer part obtained by omitting the figures below a decimal point of x. A value of sign(x) is -1 when x is negative and is 1 in other cases. When "n" is calculated, $2n\pi$ is added to phases ($\phi b$, $\phi c$, and $\phi d$) of all phase data belonging to the group B to update values of $\phi b$, $\phi c$, and $\phi d$. The group B is merged with A to form a new group C having four phase data "a" to "d" as shown in FIG. 4.

(B) A difference of average values of phases of a part of or all of phase data belonging to a group is set as an evaluation value. The phases of the phase data in the group are shifted by $2n\pi$ to minimize the evaluation value.

This is the same as (A) except that $\alpha_{BA}=(\phi b+\phi c+\phi d)/3-\phi a$ in the example in FIG. 3. In this expression, an average value of phases of the groups B is calculated with all phase data. However, rather than using all the phase data, the average value may be an average of a part of phase data by, for example, limiting the phase data to 4-neighbors to calculate the evaluation value as $\alpha_{BA}=(\phi b+\phi d)/2-\phi a$.

(C) Variance of a part of or all of phase data of a target group is set as an evaluation value. Phases of phase data in the group are shifted by $2n\pi$ to minimize the evaluation value.

This exactly means that, instead of shifting phases to reduce a difference of averages in (B), phases are shifted to minimize variance. In the example in FIG. 3 in which the target groups are A and B, phase data for which variance is calculated may be the all phase data (four phase data from "a" to "d"). The calculation may be performed only with a part of data, for example, the data adjacent in the 4-neighbors (three data excluding "d").
Unwrapping evolution concerning one-to-one merging of groups has been explained as shown in FIG. 3. The same holds true when three or more groups are merged into one group. For example, a phase shift amount of each group only has to be determined such that an evaluation value obtained on the basis of phases such as a difference, an average, or variance of phases satisfies a certain condition.
A method of applying merging to three or more groups by limiting targets to a part of the target groups will be explained. For simplicity of explanation, as shown in FIG. 5, it is assumed that four phase data are grouped into three groups.
It is considered to shift phase data of the group A to merge the phase data with B or C. In this case, plural evaluation values are calculated for each combination of merging. When it is assumed that the method (A) explained above is used as a method of calculating evaluation values and boundaries for calculating a phase difference are 8-neighbors, evaluation values $\alpha_{AB}$ and $\alpha_{AC}$ are calculated as $\alpha_{AB}=\phi a-\phi b$ and $\alpha_{AC}=((\phi a-\phi c)+(\phi a-\phi d))/2$. "n" is calculated for a group having an optimum value among evaluation values obtained for each candidate of a merging destination. A phase of data of the group A is shifted and merged.
A condition concerning an evaluation value for determining an optimum group is not specifically limited. For example, a group having a minimum absolute value of an evaluation value may be set as a merging destination. A method of calculating an evaluation value may be any method as described above. For example, merging may be performed by unwrapping evolution for a combination in which an average or variance of phases is minimized.

(Specific examples)

1. A result of acquisition of phase data

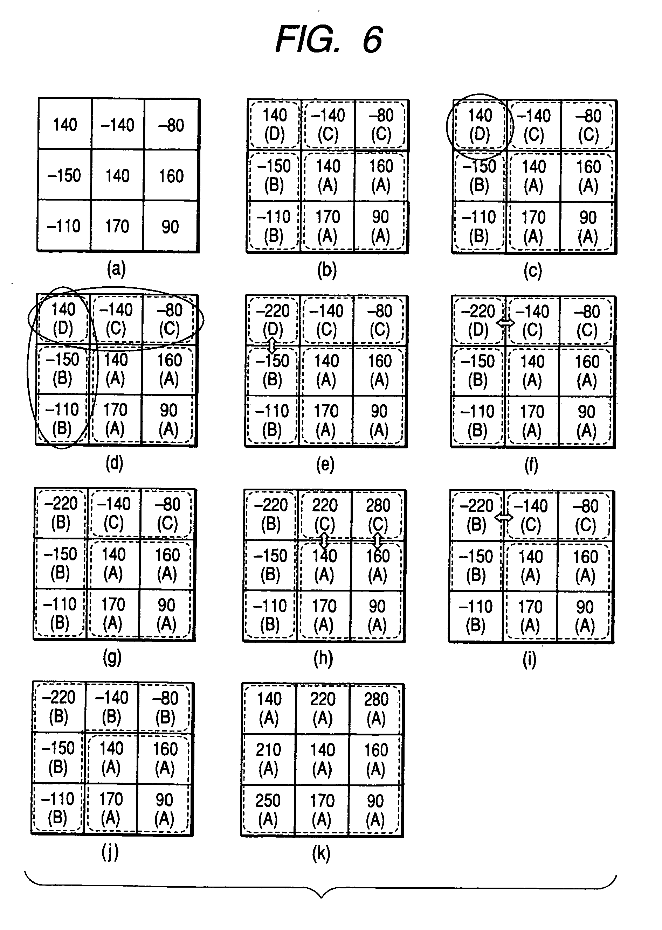

For simplicity of explanation, it is assumed that nine phase data in total consisting of three phase data x three phase data on a two-dimensional plane are obtained as shown in FIG. 6(a). Note that values shown in the figure are representation of values of phases in the respective data. A unit of the values is [deg]. The phase unwrapping evolution processing proposed in the invention will be explained using the phase data shown in FIG. 6(a) with phases unwrapped in a range of -180 to 180 [deg] as an example.

2. Grouping of phase data

Before applying unwrapping evolution to obtained phase data, first, grouping of the phase data is performed. In grouping the phase data, it is assumed that, for example, a rule that, when phases of data adjacent to each other in the 4-neighbors in the four directions of the data are compared, if a difference of the phases is within 90 [deg], the data belong to the same group and, if the difference exceeds 90 [deg], the data belong to different groups (the rule written in (1-1) above) is applied. As a result of performing grouping under the rule, as shown in FIG. 6(b), the phase data are grouped into four groups A, B, C, and D.

3. Phase unwrapping evolution by a unit of group

Phase unwrapping evolution by a unit of group that is performed after the grouping of the phase data ends will be explained assuming that, for example, the following rule is applied.

When phase unwrapping evolution is performed targeting a certain group, in a group adjacent to the target group in 4-neighbors in the four directions, unwrapping evolution for shifting phases of all data of the target group by $2n\pi$ to minimize a phase difference of phase data located at a boundary is performed and, then, the target group and the adjacent group are merged.

One-to-one merging of groups is performed every time unwrapping evolution is performed once and the processing is continued until the groups are merged into one group.

When there are plural groups adjacent to a target group of phase unwrapping evolution in 4-neighbors in the four directions, the target group is merged with a group having a smallest average of a phase difference of phase data located at boundaries by carrying out the phase unwrapping evolution.

4. Designation of a target group of unwrapping evolution

First, a target group of unwrapping evolution is designated. An order of designation of a target group is not specifically designated. For example, as shown in FIG. 6(c), a group D is designated as a target group.

5. Groups of target groups

As groups to be candidates of a merging destination adjacent to the target group D in 4-neighbors, there are two groups B and C as shown in FIG. 6(d). As determined above, there is the rule that only one-to-one merging of groups is performed every time unwrapping evolution is performed. Thus, when there are plural candidates for a combination of merging (groups of target groups), evaluation values are calculated for respective groups of target groups "D and B" and "D and C". Merging of groups is performed with a group of target groups having an optimum evaluation value.

6. Calculation of an evaluation value for each group of target groups

First, a phase shift amount at the time when the target group is subjected to unwrapping evolution is calculated for each group of target groups.

When calculation of a phase difference is performed in the case of a group of target groups 1 consisting of D and B shown in FIG. 6(e), since (140-(-150))/1=290, "n" is calculated as -1 from Expression (1). Therefore, as a result of unwrapping evolution, data of the target groups is shifted by $-2\pi$, that is, -360 [deg]. Thus, a phase of the data of the target groups is 140-360=-220 [deg]. Similarly, when calculation in the case in which unwrapping evolution is performed with a group of target groups 2 consisting of D and C shown in FIG. 6(f) is performed, a phase of data of the target groups is also -220 [deg].

In the rule determined above, with an average phase difference of boundary data after carrying out unwrapping evolution for each group of target groups as an evaluation value, one-to-one merging is performed with a pair having a smaller evaluation value. Thus, an evaluation value is calculated as follows for each of the groups of target groups.

In the case of the group of target groups 1:

$$|-220-(-150)|/1=70$$

In the case of the group of target groups 2:

$$|-220-(-140)|/1=80$$

Therefore, the group B having a smaller evaluation value is selected as a merging destination of the target group D.

7. Merging of groups

Groups of phase data present at the point when the group D is subjected to phase unwrapping evolution and merged with the group B are three groups (A, B, and C) as shown in FIG. 6(g). In the rule described above, the ending condition is that unwrapping evolution by a unit of group is applied repeatedly until groups are merged into one group. Thus, a target group is designated again to continue the same processing. Thus, the explanation is continued with the group C as a target group.

8. Repeated application of phase unwrapping evolution by a unit of group

As shown in FIGS. 6(h) and 6(i), there are two groups of target groups for the target group C. Since an average phase difference of boundary data in a group of target groups 3 consisting of C and A is ((-140)-140)+((-80)-160))/2=-260, "n" is calculated as 1 from Expression (1) above. Therefore, in the group of target groups 3, a shift amount of data by unwrapping evolution of the target group C is +360 [deg]. On the other hand, since an average phase difference in a group of target groups 4 consisting of C and B is ((-140)-(-220))/1=80, "n" is calculated as 0. Therefore, in the group of target groups 4, a phase shift amount by unwrapping evolution of the target group C is 0. In other words, data of the target group C does not fluctuate. When calculation of an evaluation value is performed in each group of target groups after phase unwrapping evolution, in the case of the group of target groups 3, |(220-140)+(280-160)|/2=100 and, in the case of the group of target groups 4, |(-140)-(-220)|/1=80. Thus, the group of target groups 4 is optimum. Therefore, the group C is merged with the group B this time.

9. A final result by application of the proposed method

At this point, the two groups (A and B) are still present as shown in FIG. 6(j). Since the ending condition of application of the processing is not satisfied, the processing is further continued with, for example, the group B as a target group. Since a group of target groups at this point is only one pair of B and A, the processing does not reach selection of a group of target groups by calculation of an evaluation value. When the group B is subjected to unwrapping evolution and merged with the group A, only one group is left. Thus, the application of the method proposed in the invention ends.

FIG. 6(k) shows a phase map that is finally obtained by phase unwrapping evolution by a unit of group.

Note that, in the above explanation, the condition of grouping, the way of forming a pair of phase data for calculating a phase difference, the ending condition of the phase unwrapping evolution processing by a unit of group, and the like are always the same during the processing. However, the conditions are only an example. Conditions are not limited to the conditions and it is possible to adopt arbitrary conditions. It is also possible that conditions are changed in the middle of the processing.

The above explanation is an explanation of the procedure in the invention. As it is evident from the explanation, in the invention, as the unwrapping evolution processing proceeds, groups increase and information on a phase difference among the group increases. Thus, the influence of phase data that tends to be a cause of failure of unwrapping evolution gradually decreases, robustness becomes higher than that in the conventional method, and a more correct result is obtained. In addition, a group once subjected to unwrapping evolution continues to be subjected to unwrapping evolution as a new group created by merging. Thus, even if a phase is decided once, the group is subjected to unwrapping evolution many times in order to match the phase with phases of other groups. As a result, it is possible to prevent a series of occurrence of failure of unwrapping evolution. Failure of unwrapping evolution is reduced compared with the conventional method and stability of unwrapping evolution is improved.

Note that, in the above explanation, for simplicity of explanation, phase unwrapping evolution is limited to the case in which phase data is present only on two dimensions. However, the same holds true in the case in which phase data is present on three dimensions. In that case, phase data seen as neighborhoods of a boundary is simply evolved in three-dimensional directions as well.

The method may be applied to all phase data at a time. Alternatively, the method may be applied stepwise while an application area of the method is extended in such a manner that phase data is divided into certain areas and the method is applied in the respective areas independently and, then, applied in a large area. For example, it is also possible that, first, the method is independently applied by a unit of two-dimensional plane and, after phases are matched in a two-dimensional plane shape, phase data of the respective two-dimensional planes are consolidated as one group and the method is applied to three dimensions this time. In that case, an evaluation value used in phase unwrapping evolution for each stage may be continuously the same or may be changed according to a step.

Phases among phase data are matched by the application of the method explained above. However, it is likely that several offsets are still added to values of the phases as a whole. In some cases, it is conceivable that only matching among phases is not an object, a phase has some meaning, and it is desired to adjust an offset by shifting overall phase data by a certain amount in order to use the phase as an appropriate value depending on processing. In such a case, for example, it is conceivable that some evaluation values such as average values of phases are compared before and after application of the method and overall phases are shifted to minimize the evaluation values.

As another example, it is conceivable that, when the invention is applied to data processing such as shimming in an MRI apparatus, a center frequency is calculated separately and a phase is shifted by the center frequency after application of the method.

An embodiment of an MRI apparatus to which the invention is applied will be hereinafter explained.

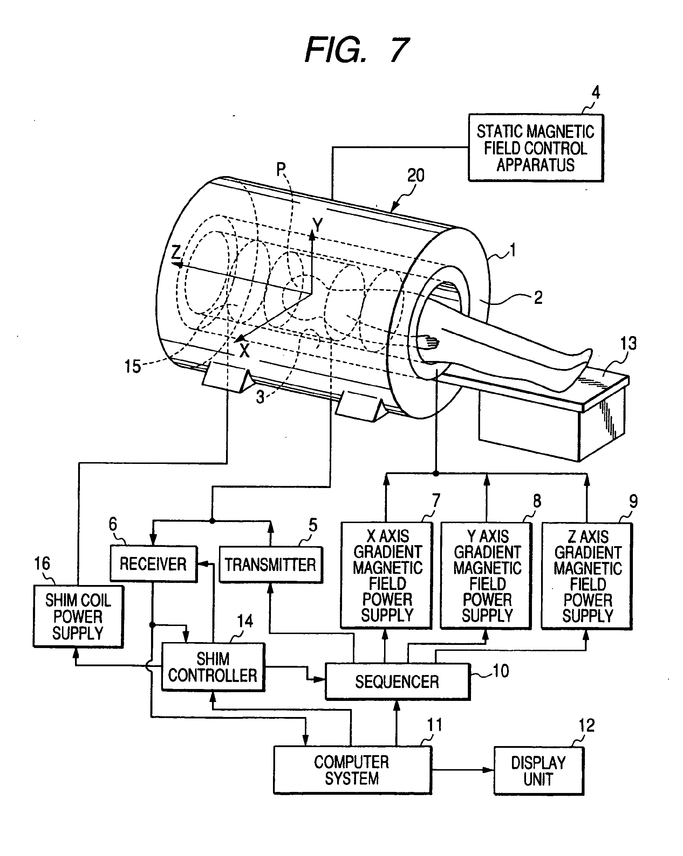

FIG. 7 is a diagram of a basic constitution of the MRI apparatus in this embodiment. In a gantry 20 having a cylindrical internal space to make it possible to house a patient P, a static magnetic field magnet 1, an XYZ axis gradient magnetic field coil 2, an RF coil 3, and a multi-channel type shim coil 15 are provided. The static magnetic field magnet 1, which is a normal conducting magnet or a superconducting magnet, is constituted to be capable of receiving supply of an electric current from a static magnetic field control apparatus 4 and usually forming a static magnetic field along a Z axis in a cylinder. The XYZ axis gradient magnetic field coil 2 includes three sets of coils that receive supply of electric currents from gradient magnetic field power supplies 7, 8, and 9 corresponding to X, Y, and Z axes and create gradient magnetic fields of the X, Y, and Z axis for arbitrarily determining an imaging section or area and giving spatial position information to a magnetic resonance signal. It is possible to collect magnetic resonance signals in an area in which all magnetic field intensities in the three directions change linearly. When the magnetic resonance signals are collected, in a state in which the patient P is placed on a top plate of a bed 13, the patient P is inserted into an imaging area following sliding of the top plate.

The RF coil 3 is a coil for transmitting an RF pulse (also referred to as high-frequency magnetic field or rotating magnetic field) to a patient and receiving a magnetic resonance signal from the patient. Instead of using the RF coil 3 for both transmission and reception in this way, a transmission coil and a reception coil may be provided separately. A transmitter 5 is a device for supplying a high-frequency pulse corresponding to a Larmor frequency peculiar to a target atomic nucleus to the RF coil 3 to bring spin of the target atomic nucleus into an excited state. A receiver 6 has a function for receiving a high-frequency magnetic resonance signal, which is emitted in a process in which the excited spin relaxes, via the RF coil 3, amplifying the magnetic resonance signal, subjecting the magnetic resonance signal to quadrature phase detection, and further subjecting the magnetic resonance signal to analog/digital conversion.

A computer system 11 captures the magnetic resonance signal digitized by the receiver 6 and subjects the magnetic resonance signal to two-dimensional Fourier transformation (2DFT) to thereby reconstitute a magnetic resonance image. This image is displayed on a display unit 12. A sequencer 10 controls operation timings for the transmitter 5, the receiver 6, and the gradient magnetic field power supplies 7, 8, and 9 for the X, Y, and Z axis and executes a pulse sequence for determining a shimming value and a pulse sequence for imaging.

In this embodiment, both shimming by the shim coil and shimming called an FUC method (Field Uniformity Correction method) performed by giving an offset to a gradient magnetic field are used. The FUC method is a method of directly correcting a first-order non-uniform component of a static magnetic field by superimposing offsets on gradient magnetic fields Gx, Gy, and Gz. In this embodiment, the FUC method is used to make it possible to indirectly correct a higher order, that is, second-order non-uniform component. A principle of realizing the indirect correction is in a method of determining a shimming value. Details of the principle will be described later.

The multi-channel type shim coil 15 includes plural shim coils that correct a high-order non-uniform magnetic field component that are not directly and indirectly corrected by the FUC method and have different non-uniform magnetic field components of static magnetic fields to be corrected. In general, shim coils for thirteen channels or eighteen channels are prepared. In this embodiment, as in the FUC method, it is made possible to indirectly correct components other than a non-uniform component indirectly corrected by each of the shim coils, respectively. A shim coil power supply 16 is constituted to be capable of independently supplying electric currents (shim currents) to each of the plural shim coils of the multi-channel type shim coil 15.

A shim controller 14 captures the magnetic resonance signal digitized by the receiver 6, calculates a spatial magnetic field distribution on the basis of the magnetic resonance signal, and calculates a shimming value for each component on the basis of the magnetic field distribution. Then, the shim controller 14 supplies to the shim coil power supply 16 a shimming value of a non-uniform component to be corrected by the multi-channel type shim coil 15 while changing the shimming value according to movement of a partial area where data is collected. The shim coil power supply 16 supplies a shim current corresponding to the shimming value to a shim coil corresponding thereto.

The shim controller 14 sets a shimming value of a first-order non-uniform component as an offset value and supplies the offset value to the sequencer 10 while changing the offset value according to movement of a partial area where data is collected. The sequencer 10 adds the offset value to a criteria value and supplies the added value to the gradient magnetic field power supplies 7, 8, and 9. The gradient magnetic field power supplies 7, 8, and 9 supply a gradient magnetic field current corresponding to the added value to the XYZ axis gradient magnetic field coil 2. Consequently, a first-order component is shimmed. The shim controller 14 adjusts a reference frequency of quadrature phase detection in the receiver 6 according to a shimming value corresponding to a zero-th component, that is, shift of a resonant frequency to thereby shim the zero-th component.

An example of a method of determining a shimming value will be explained.

Shimming means correcting a non-uniform magnetic field component in order to improve uniformity of static magnetic fields in a target area as much as possible. As a method of calculating a shimming value, there are the following methods.

> (1) Acquire a magnetic resonance signal from a target area without superimposing a gradient magnetic field thereon and calculate a shim current value with a longest signal attenuation time constant of the magnetic resonance signal.
> (2) Acquire a magnetic resonance signal from a target area without superimposing a gradient magnetic field thereon, subject the magnetic resonance signal to Fourier transformation, and calculate a shim current value minimizing a frequency band of conversion data of the magnetic resonance signal.
> (3) Spatially calculate a magnetic field distribution as a phase map, evolve (resolve) the magnetic field distribution for each magnetic field component set as a target of shimming, and calculate a shim current value required for obtaining magnetic field intensity stabilizing a magnetic field distribution for each magnetic field component.

A best one among the methods is the method of (3). The method of (3) is adopted in this embodiment. In this method, for example, considering that an extremely thin slice area with thickness of 3 mm is an object of concern and a slice direction is a most general Z direction, fall in accuracy is apprehended when components z1, z3, z5, and the like representing non-uniformity in the Z direction are calculated from a magnetic field distribution only in the thin one slice area. In this embodiment, the apprehension is solved by calculating the components from a magnetic field distribution of a wide area, that is, entire plural slice areas.

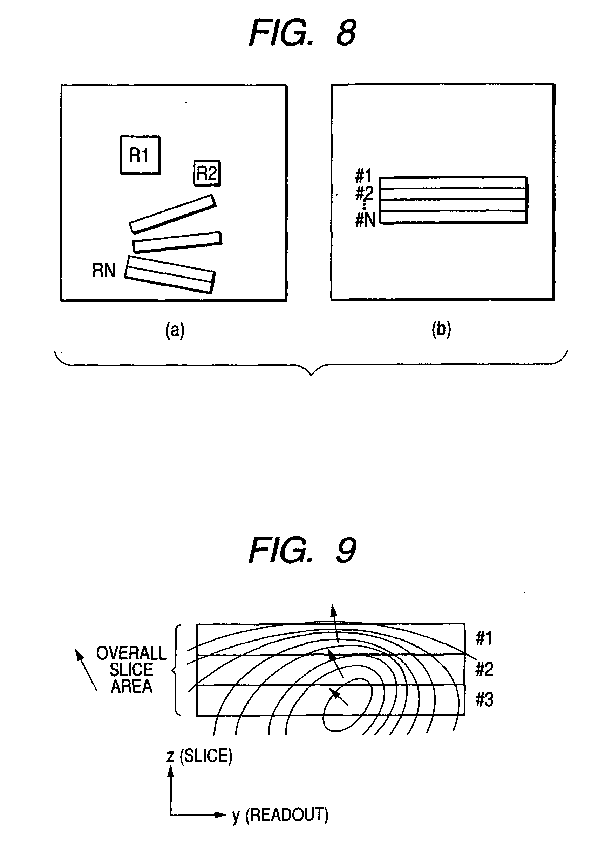

In this embodiment, in correcting a non-uniform component in a static magnetic field, a shimming value is calculated for each spatially different partial area and the non-uniform component of the static magnetic field is corrected with the shimming value different for each partial area. For example, in a multi-slice method, a magnetic field distribution for a wide area over plural slice areas, that is, a magnetic field distribution (a second-order magnetic field in the FUC method) higher in order than a non-uniform component of an n-th order term (n=1 in the FUC method) of a static magnetic field to be corrected is calculated, a shape of the magnetic field distribution is approximated by an n-th order equation (a linear equation in the FUC method), and a shimming value of each magnetic field component on the basis of the n-th order equation is obtained. Note that the spatially different partial area means, for example, an arbitrary sectional area shown in FIG. 8(a) and a slice area obtained by the multi-slice method shown in FIG. 8(b).

A method of determining shimming values of a zero-th order component and a first-order component will be specifically explained with the case in which the multi-slice method is also used as an example.

FIG. 9 shows a magnetic field distribution on a Y-Z plane orthogonal to the slice areas #1 to #3. In general, an average first-order component of an entire area over the slice areas #1 to #3 is calculated by any one of the methods (1) to (3) and correction is performed using an identical shimming value (offset value) for all the slice areas #1 to #3. However, in this embodiment, a shimming value of a first-order component is calculated for each slice area and a different shimming value is used for each slice area to give an offset to a gradient magnetic field.

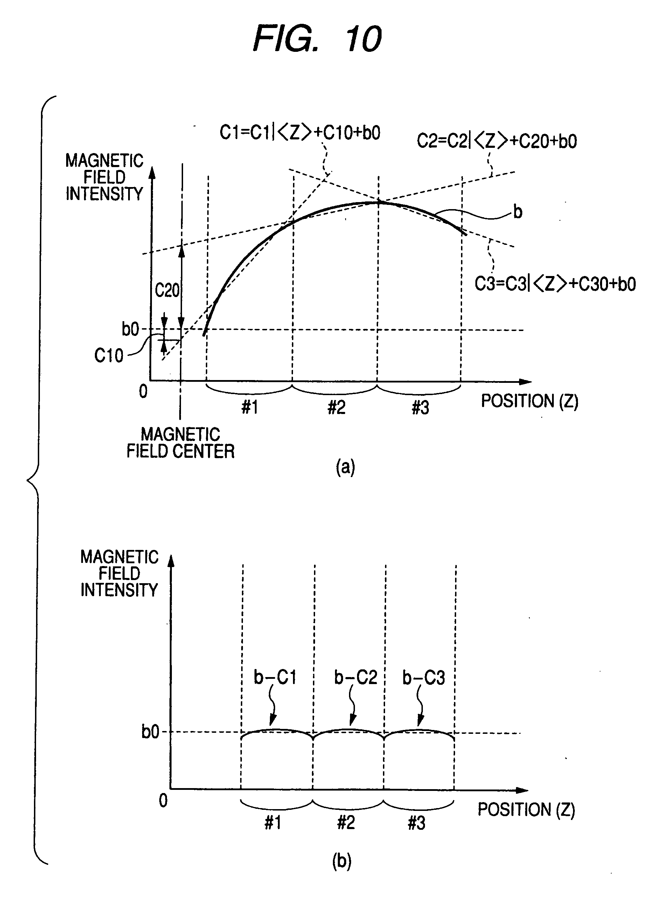

A magnetic field distribution in the Z axis direction is shown in FIG. 10(a). A magnetic field distribution "b" shows a curve like a parabola. In the entire slice areas #1 to #3, it is observed that the magnetic field distribution "b" has an intensity distribution of a second order or more. The magnetic field distribution is linearly approximated by a linear equation as indicated in by following expressions (1), (2), and (3) for each of the slice areas #1 to #3.

$$\text{Slice area \#1; } C1=c11(Z)+c10+b0 \qquad (1)$$

$$\text{Slice area \#2; } C2=c21(Z)+c20+b0 \qquad (2)$$

$$\texttt{Slice area \#3; C3=c31(Z)+c30+b0} \qquad (3)$$

Therefore, a shimming value of a zero-th order component for the slice area #1 is given as -c10, a shimming value of a first-order component for the slice area #1 is given as -c11, a shimming value of a zero-th component for the slice area #2 is given as -c20, a shimming value of a first-order component for the slice area #2 is given as -c21, a shimming value of a zero-th order component for the slice area #3 is given as -c30, and a shimming value of a first-order component for the slice area #3 is given as -c31.

Shimming for a first-order component is realized by giving an offset to a gradient magnetic field according to a shimming value of the first-order component. Shimming for a zero-th component, that is, shift of a resonance frequency is realized by adjusting a reference frequency of quadrature phase detection in the receiver 6 according to a shimming value of the zero-th component.

Consequently, as shown in FIG. 10(b), it is seen that the magnetic field distribution after correction is approximated to a criteria magnetic field intensity b0 for the respective slice areas and accuracy of uniformity is improved. It would be understood that shimming is applied not only to a first-order component to which it is possible to directly apply shimming in the FUC method but also to a second-order component in an approximate manner.

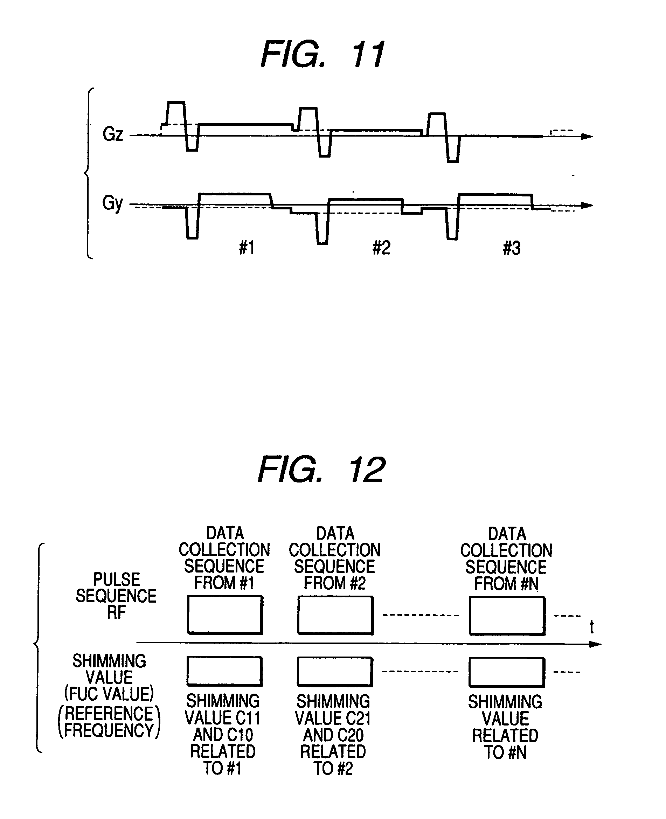

A pulse sequence in the case in which the multi-slice method is used together with a field echo method is shown in FIG. 11 as an example. Correspondence in time series between execution of a pulse sequence and use of a shimming value is shown in FIG. 12. An offset of a gradient magnetic field is changed for each of the slice areas #1 to #3 in accordance with the shimming value calculated for each of the slice areas #1 to #3.

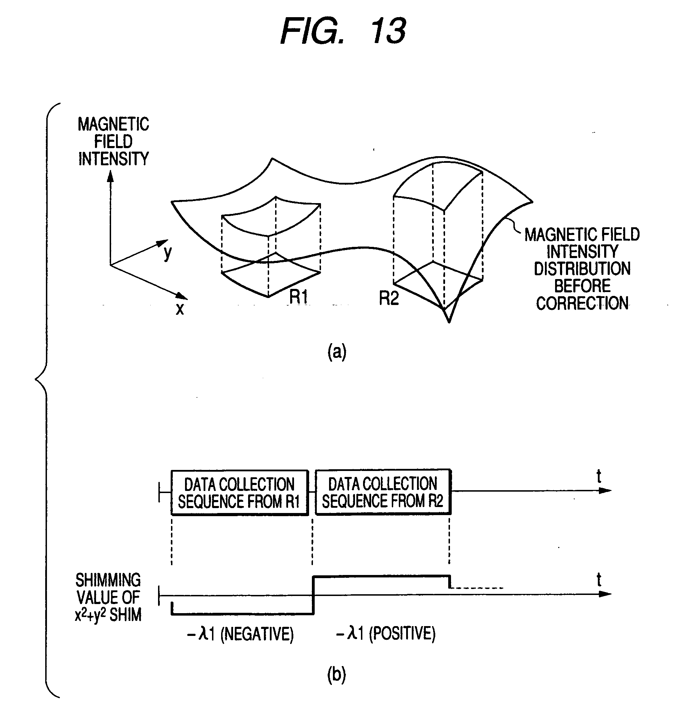

A second-order magnetic distribution before correction is shown in FIG. 13(a) (for convenience of explanation, shown only for XY). It is seen that, as shown in FIG. 13(b), components of a magnetic field distribution of an $X^2+Y^2$ type are different on partial areas R1 and R2. Since R1 shows a concave shape, an $X^2+Y^2$ component $\lambda 1$ is negative. Since R2 shows a convex shape, an $X^2+Y^2$ component $\lambda 2$ is positive. Therefore, a shimming value given to an $X^2+Y^2$ shim coil is given according to $-\lambda 1$ in the partial area R1 and is given according to $-\lambda 2$ in R2.

In the MRI apparatus according to the constitution described above, when a non-uniform component of a static magnetic field is corrected, a shimming value is calculated for each spatially different partial area and a non-uniform component of a static magnetic field is corrected for each partial area on the basis of respective shimming values. According to the method, a shimming value is calculated for each spatially different partial area like a slice in the multi-slice method and a non-uniform component of a static magnetic field is corrected for each partial area on the basis of respective shimming values. Thus, uniformity of the static magnetic field is improved and an effect of the correction extends to a component higher in order than a non-uniform component directly corrected by a shimming value calculated. It is possible to perform correction of non-uniformity of the static magnetic field at higher accuracy. This makes it possible to obtain a satisfactory image with less artifact even in imaging in which high magnetic field uniformity is required such as echo planar imaging (EPI), spectroscopy (MRS), spectroscopy imaging (MRSI), water fat separation, and fat control.

When a first-order component of a non-uniform static magnetic field is corrected by offset of a gradient magnetic field, an offset value is calculated for spatially different partial area and the first-order component of the non-uniform static magnetic field is corrected for each partial area on the basis of respective offset values. According to the method, since an offset value is calculated for each spatially different partial area like a slice in the multi-slice method and a first-order component of a non-uniform static magnetic field is corrected for each partial area on the basis of respective offset values. Thus, uniformity of the static magnetic field is improved and an effect of the correction extends to a component in an order equal to or higher than a second order. It is possible to perform correction of non-uniformity of the static magnetic field at higher accuracy. This makes it possible to obtain a satisfactory image with less artifact even in imaging in which high magnetic field uniformity is required such as echo planar imaging (EPI), spectroscopy (MRS), spectroscopy imaging (MRSI), water fat separation, and fat control. Moreover, it is possible to cope with the effect only through a software change of calculating an offset value for each partial area.

In such an MRI apparatus, when a phase map is created in shimming processing for correcting a non-uniform component of a magnetic field, phase unwrapping evolution is performed.

In the phase unwrapping evolution, in the conventional method, as shown in FIG. 1, it is highly likely that unwrapping evolution fails because of an influence of noise when data having steep phase change compared with data around the data such as phase data located at a boundary of tissues and phase data including noise. Thus, the phase unwrapping evolution method according to the invention is applied at the time of phase map creation in the shimming processing.

When the phase unwrapping evolution method according to the invention is applied, grouping for grouping phase data obtained by shimming under a predetermined condition is performed to match phases among at least two groups. In this case, after phases of all phase data in an arbitrary group subjected to the grouping are shifted by a predetermined amount and subjected to unwrapping evolution by a unit of group, phases are matched with phases of the other groups. In order to match phases, a center frequency is calculated separately for each group in advance and phases are shifted by the center frequency.

By executing the processing described above, even when data having a steep phase change compared with data around the data is present at the time of phase map creation in the shimming processing, it is possible to surely perform unwrapping evolution and remarkably reduce failure due to an influence of noise.

Since groups increase as the unwrapping evolution processing advances and information on a phase difference among the groups increases, it is possible to remarkably reduce an influence of phase data that tends to cause failure of unwrapping evolution. Thus, robustness is higher than that in the conventional method. In addition, a group once subjected to unwrapping evolution continues to be subjected to unwrapping evolution as a new group created by merging. Thus, even if a phase is decided once, the group is subjected to wrapping evolution many times in order to match the phase with phases of other groups. As a result, it is possible to prevent a series of occurrence of failure of unwrapping evolution. Failure of unwrapping evolution is reduced compared with the conventional method and stability of unwrapping evolution is improved.

Note that it is assumed that the unwrapping evolution method according to the invention includes performance of additional processing for deciding a phase after execution of the unwrapping evolution method.

The invention is not limited to the embodiment itself. It is possible to embody the invention by modifying the components without departing from the spirit of the invention at a stage of carrying out the invention. It is possible to form various inventions according to appropriate combinations of the plural components disclosed in the embodiment. For example, several components may be deleted from all the components described in the embodiment. Moreover, components used in different embodiments may be appropriately combined.

Industrial Applicability

The unwrapping evolution method according to the invention is applied in, for example, data processing in an MRI (Magnetic Resonance Imaging) apparatus at the time of creation of a phase map.

**Claims**

1. A phase unwrapping evolution method of subjecting phases of plural phase data in a target area to unwrapping evolution, respectively, to decide a phase, the phase unwrapping evolution method comprising:

   a first step of grouping the phase data under a predetermined condition; and
   a second step of matching phases among at least two groups grouped in the first step,

   wherein, in the second step, phases of all phase data in an arbitrary group subjected to the grouping are shifted by a predetermined amount and subjected to unwrapping evolution by a unit of group and, then, phases are matched between the group and the other groups.

2. A phase unwrapping evolution method according to claim 1, further comprising a third step of creating a group anew by merging arbitrary number of groups among a group of target groups subjected to unwrapping evolution in the second step.

3. A phase unwrapping evolution method according to claim 2, wherein, in the third step, it is judged whether there are plural candidates of a combination of groups of groups including at least one specific group subjected to unwrapping evolution by a unit of group according to processing in the second step, when there are plural candidates, an evaluation value based on phases among the respective groups is calculated for each of the groups of groups, unwrapping evolution is performed by a unit of the group targeting a group of groups having an optimum evaluation value, and, then, an arbitrary number of groups among the group of groups are merged to create a group anew.

4. A phase unwrapping evolution method according to claim 2, wherein the phase unwrapping evolution method includes a routine for repeatedly executing the merger of the groups in the third step and the unwrapping evolution by a unit of group in the second step.

5. A phase unwrapping evolution method according to claim 4, wherein the target area is divided into plural areas, phase unwrapping evolution in the first to the third steps is executed for each divided area independently, and an area is enlarged stepwise to execute the phase unwrapping evolution.

6.  A phase unwrapping evolution method according to claim 3, wherein phases of phase data after the phase unwrapping evolution are shifted such that fluctuation in an evaluation value calculated on the basis of the phases of the phase data before and after the phase unwrapping evolution is optimized.

7.  A phase unwrapping evolution method according to claim 6, wherein, after the execution of the phase unwrapping evolution, the phase of the phase data are shifted by a certain value calculated separately.

8.  A phase unwrapping evolution method according to claim 1, wherein, as a condition for grouping of the phase data, if an evaluation value calculated on the basis of phases of arbitrary phase data is equal to or smaller than a certain threshold value, the phase data is regarded as belonging to a same group.

9.  A phase unwrapping evolution method according to claim 1, wherein, as a condition for grouping of the phase data, if a difference between an evaluation value calculated on the basis of a phase of phase data in a certain group and a phase of phase data, for which a belonging group is undecided, is equal to or smaller than a certain threshold value, the phase data is regarded as belonging to a same group.

10. A phase unwrapping evolution method according to claim 8 or 9, wherein the threshold value is within a range of 30 to 90 [deg].

11. A phase unwrapping evolution method according to claim 1, wherein, as a condition for grouping of the phase data, when an evaluation value is calculated on the basis of a phase of phase data of a certain group, if fluctuation in the evaluation value that occurs when phase data, for which a belonging group is undecided, is added to the group is within a certain threshold value, the phase data is regarded as belonging to a same group.

12. A phase unwrapping evolution method according to claim 1, wherein, as a condition for grouping of the phase data, the phase data is classified into an arbitrary shape.

13. A phase unwrapping evolution method according to claim 1, wherein, as a condition for grouping of the phase data, at least any plural conditions among a first condition that, if an evaluation value calculated on the basis of phases of arbitrary phase data is within a certain threshold value, the phase data belong to a same group, a second condition that, if a difference between an evaluation value calculated on the basis of a phase of phase data of a certain group and a phase of phase data, for which a belonging group is undecided, is within a certain threshold value, the phase data belong to a same group, a third condition that, when an evaluation value is calculated on the basis of a phase of phase data of a certain group, if fluctuation in the evaluation value that occurs when phase data, for which a belonging group is undecided, is added to the group is within a certain threshold value, the phase data belong to a same group, and a fourth condition that phase data is classified into an arbitrary shape, are arbitrarily combined and applied.

14. A phase unwrapping evolution method according to claim 1, further comprising a fourth step of shifting, by a certain value, a phase of phase data subjected to the grouping in the first step and subjected to matching of phases in the second step.

15. A magnetic resonance imaging apparatus that performs shimming processing with an object of correcting a non-uniform component of a magnetic field, the magnetic resonance imaging apparatus comprising:

    grouping means that groups phase data of a phase map representing a distribution of fluctuation amounts of phases due to non-uniformity of the magnetic field under a predetermined condition; and
    phase matching means that matches phases among at least two groups grouped by the grouping means,

    wherein the phase matching means shifts phases of all phase data in an arbitrary group subjected to the grouping by a predetermined amount and performs unwrapping evolution by a unit of group and, then, matches phases between the group and the other groups.

16. A magnetic resonance imaging apparatus according to claim 15, further comprising group merging means that creates a group anew by merging arbitrary number of groups among a group of target groups subjected to unwrapping evolution by the phase matching means.

17. A magnetic resonance imaging apparatus according to claim 16, wherein, the group merging means judges whether there are plural candidates of a combination of groups of groups including at least one specific group subjected to unwrapping evolution by a unit of group according to processing of the phase adjusting means, when there are plural candidates, calculates an evaluation value based on phases among the respective groups for each of the groups of groups, performs unwrapping evolution targeting a group of groups having an optimum evaluation value, and, then, merges an arbitrary number of groups among the group of groups to create a group anew.

18. A magnetic resonance imaging apparatus according to claim 16, wherein the magnetic resonance imaging apparatus includes a routine for repeatedly executing the merger of the groups by the group merging means and the unwrapping evolution by a unit of group by the phase matching means.

19. A magnetic resonance imaging apparatus according to claim 16, wherein the magnetic resonance imaging apparatus divides the target area into plural areas, executes phase unwrapping evolution by the grouping means, the phase matching means, and the group merging means for each divided area independently, and enlarges an area stepwise to execute the phase unwrapping evolution.

20. A magnetic resonance imaging apparatus according to claim 17, wherein the phase matching means shifts phases of phase data after the phase unwrapping evolution such that fluctuation in an evaluation value calculated on the basis of the phases of the phase data before and after the phase unwrapping evolution is optimized.

21. A magnetic resonance imaging apparatus according to claim 20, wherein, after the execution of the phase unwrapping evolution, the phase matching means shifts the phase of the phase data by a certain value calculated separately.

22. A magnetic resonance imaging apparatus according to claim 15, wherein the grouping means regards that, as a condition for grouping of the phase data, if an evaluation value calculated on the basis of phases of arbitrary phase data is equal to or smaller than a certain threshold value, the phase data belong to a same group.

23. A magnetic resonance imaging apparatus according to claim 15, wherein the grouping means regards that, as a condition for grouping of the phase data, if a difference between an evaluation value calculated on the basis of a phase of phase data in a certain group and a phase of phase data, for which a belonging group is undecided, is equal to or smaller than a certain threshold value, the phase data belong to a same group.

24. A magnetic resonance imaging apparatus according to claim 22 or 23, wherein the threshold value is within a range of 30 to 90 [deg].

25. A magnetic resonance imaging apparatus according to claim 15, wherein the grouping means regards that, as a condition for grouping of the phase data, when an evaluation value is calculated on the basis of a phase of phase data of a certain group, if fluctuation in the evaluation value that occurs when phase data, for which a belonging group is undecided, is added to the group is within a certain threshold value, the phase data belong to a same group.

26. A magnetic resonance imaging apparatus according to claim 15, wherein the grouping means classifies the phase data into an arbitrary shape as a condition for grouping of the phase data.

27. A magnetic resonance imaging apparatus according to claim 15, wherein, as a condition for grouping of the phase data in the grouping means, at least any plural conditions among a first condition that, if an evaluation value calculated on the basis of phases of arbitrary phase data is within a certain threshold value, the phase data is regarded as belonging to a same group, a second condition that, if a difference between an evaluation value calculated on the basis of a phase of phase data of a certain group and a phase of phase data, for which a belonging group is undecided, is within a certain threshold value, the phase data is regarded as belonging to a same group, a third condition that, when an evaluation value is calculated on the basis of a phase of phase data of a certain group, if fluctuation in the evaluation value that occurs when phase data, for which a belonging group is undecided, is added to the group is within a certain threshold value, the phase data is regarded as belonging to a same group, and a fourth condition that phase data is classified into an arbitrary shape, are arbitrarily combined and applied.

28. A magnetic resonance imaging apparatus according to claim 15, further comprising phase shift means that shifts, by a certain value, a phase of phase data subjected to the grouping by the grouping means and subjected to matching of phases by the phase matching means.

*FIG. 1*

UNWRAPPING EVOLUTION PROCESSING ORDER

SINCE DIFFERENCE FROM TRUE VALUE IS LARGER, PHASE WITH SMALLER DIFFERENCE IS MISS-ESTIMATED AS TRUE PHASE

NOISE

( WITH MISS-ESTIMATION DUE TO NOISE AS TRIGGER, ALL TRUE PHASES ARE MISS-ESTIMATED AFTER THAT )

PHASE [deg]

300  240  180  120  60  0  -60  -120  -180  -240  -300

UNWRAPPED PHASE    TRUE PHASE    MISS-ESTIMATED PHASE

# FIG. 2

```
        ( START )
            │
            ▼
┌───────────────────────────┐  S1
│     GROUPING OF PIXELS     │
└───────────────────────────┘
            │
            ▼
┌───────────────────────────┐  S2
│ PHASE UNWRAPPING EVOLUTION │
│      APPLIED TO GROUPS     │
└───────────────────────────┘
            │
            ▼
┌───────────────────────────┐  S3
│      MERGER OF GROUPS      │
└───────────────────────────┘
            │
            ▼
           ╱╲            S4
          ╱  ╲
    NO   ╱ ENDING ╲
◄───────╱ CONDITION IS ╲
         ╲ SATISFIED  ╱
          ╲   ?     ╱
           ╲╱
            │ YES
            ▼
        ( END )
```

# FIG. 3

c   d

GROUP B

a   b

GROUP A

# FIG. 4

c       d

a       b

GROUP C

# FIG. 5

GROUP C

c       d

GROUP A    a     b    GROUP B

## FIG. 6

(a)

| 140 | −140 | −80 |
| −150 | 140 | 160 |
| −110 | 170 | 90 |

(b)

| 140 (D) | −140 (C) | −80 (C) |
| −150 (B) | 140 (A) | 160 (A) |
| −110 (B) | 170 (A) | 90 (A) |

(c)

| 140 (D) | −140 (C) | −80 (C) |
| −150 (B) | 140 (A) | 160 (A) |
| −110 (B) | 170 (A) | 90 (A) |

(d)

| 140 (D) | −140 (C) | −80 (C) |
| −150 (B) | 140 (A) | 160 (A) |
| −110 (B) | 170 (A) | 90 (A) |

(e)

| −220 (D) | −140 (C) | −80 (C) |
| −150 (B) | 140 (A) | 160 (A) |
| −110 (B) | 170 (A) | 90 (A) |

(f)

| −220 (D) | −140 (C) | −80 (C) |
| −150 (B) | 140 (A) | 160 (A) |
| −110 (B) | 170 (A) | 90 (A) |

(g)

| −220 (B) | −140 (C) | −80 (C) |
| −150 (B) | 140 (A) | 160 (A) |
| −110 (B) | 170 (A) | 90 (A) |

(h)

| −220 (B) | 220 (C) | 280 (C) |
| −150 (B) | 140 (A) | 160 (A) |
| −110 (B) | 170 (A) | 90 (A) |

(i)

| −220 (B) | −140 (C) | −80 (C) |
| −150 (B) | 140 (A) | 160 (A) |
| −110 (B) | 170 (A) | 90 (A) |

(j)

| −220 (B) | −140 (B) | −80 (B) |
| −150 (B) | 140 (A) | 160 (A) |
| −110 (B) | 170 (A) | 90 (A) |

(k)

| 140 (A) | 220 (A) | 280 (A) |
| 210 (A) | 140 (A) | 160 (A) |
| 250 (A) | 170 (A) | 90 (A) |

# FIG. 7

# FIG. 8

(a)        (b)

# FIG. 9

# FIG. 10

$C1=C1|\langle Z\rangle+C10+b0$        $C2=C2|\langle Z\rangle+C20+b0$

MAGNETIC
FIELD
INTENSITY

b

C20

b0

C10

$C3=C3|\langle Z\rangle+C30+b0$

0        POSITION (Z)

#1        #2        #3

MAGNETIC
FIELD CENTER

(a)

MAGNETIC
FIELD
INTENSITY

b−C1        b−C2        b−C3

b0

0        POSITION (Z)

#1        #2        #3

(b)

# FIG. 11

Gz

Gy

#1    #2    #3

# FIG. 12

| PULSE SEQUENCE RF | DATA COLLECTION SEQUENCE FROM #1 | DATA COLLECTION SEQUENCE FROM #2 | | DATA COLLECTION SEQUENCE FROM #N | |
|---|---|---|---|---|---|
| | □ | □ | - - - - - - - - | □ | - - - t |
| SHIMMING VALUE (FUC VALUE) (REFERENCE FREQUENCY) | □ SHIMMING VALUE C11 AND C10 RELATED TO #1 | □ SHIMMING VALUE C21 AND C20 RELATED TO #2 | - - - - - - - - | □ SHIMMING VALUE RELATED TO #N | - - - |

# FIG. 13

MAGNETIC
FIELD
INTENSITY

$y$

$x$

R1    R2

MAGNETIC FIELD
INTENSITY
DISTRIBUTION
BEFORE
CORRECTION

(a)

| DATA COLLECTION SEQUENCE FROM R1 | DATA COLLECTION SEQUENCE FROM R2 | t |

SHIMMING
VALUE OF
$x^2+y^2$ SHIM

$t$

$-\lambda 1$ (NEGATIVE)     $-\lambda 1$ (POSITIVE)

(b)

## INTERNATIONAL SEARCH REPORT

| | International application No. |
|---|---|
| | PCT/JP2005/018822 |

A. CLASSIFICATION OF SUBJECT MATTER
**A61B5/055**(2006.01)

According to International Patent Classification (IPC) or to both national classification and IPC

B. FIELDS SEARCHED

Minimum documentation searched (classification system followed by classification symbols)
**A61B5/055**(2006.01)

Documentation searched other than minimum documentation to the extent that such documents are included in the fields searched

| Jitsuyo Shinan Koho | 1922-1996 | Jitsuyo Shinan Toroku Koho | 1996-2006 |
|---|---|---|---|
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | Mark Jenkinson, Fast, Automated, N-Dimensional Phase-Unwrapping Algorithm, Magnetic Resonance in Medicine, 2003 January, Vol.49, No.1, pages 193 to 197 | 15-24,26-28 |
| A | JP 2002-306445 A (Hitachi Medical Corp.), 22 October, 2002 (22.10.02), Column 10, line 38 to column 11, line 14 & WO 2002-082994 A1 & US 2004/0135577 A1 | 15-28 |
| A | Li An et al., A Fast Implementation of the Minimum Spanning Tree Method for Phase Unwrapping, IEEE TRANSACTIONS ON MEDICAL IMAGING, 2000, August, Vol.19, No.8, pages 805 to 808 | 15-28 |

☒ Further documents are listed in the continuation of Box C. ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 05 January, 2006 (05.01.06) | 17 January, 2006 (17.01.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

| | International application No. |
|---|---|
| | PCT/JP2005/018822 |

C (Continuation). DOCUMENTS CONSIDERED TO BE RELEVANT

| Category* | Citation of document, with indication, where appropriate, of the relevant passages | Relevant to claim No. |
|---|---|---|
| A | Jarle Strand et al., Two-Dimensional Phase Unwrapping Using Robust Derivative Estimation and Adaptive Integration, IEEE TRANSACTIONS ON IMAGE PROCESSING, 2002, October, Vol.11, No.10, pages 1192 to 1200 | 15-28 |
| A | JP 2000-237160 A (Hitachi Medical Corp.), 05 September, 2000 (05.09.00), Column 6, lines 29 to 50 (Family: none) | 21,28 |

Form PCT/ISA/210 (continuation of second sheet) (April 2005)

## INTERNATIONAL SEARCH REPORT

International application No.

PCT/JP2005/018822

**Box No. II    Observations where certain claims were found unsearchable (Continuation of item 2 of first sheet)**

This international search report has not been established in respect of certain claims under Article 17(2)(a) for the following reasons:

1. ☒ Claims Nos.: 1-14
    because they relate to subject matter not required to be searched by this Authority, namely:
    The subject matter stated in claims 1-14 is an algorithm of phase fold-back development and corresponds to "a theory of science and mathematics".

2. ☐ Claims Nos.:
    because they relate to parts of the international application that do not comply with the prescribed requirements to such an extent that no meaningful international search can be carried out, specifically:

3. ☐ Claims Nos.:
    because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**      ☐ The additional search fees were accompanied by the applicant's protest and, where applicable,
the                                   payment of a protest fee..

                                 ☐ The additional search fees were accompanied by the applicant's protest but the applicable protest
                                    fee was not paid within the time limit specified in the invitation.

                                 ☐ No protest accompanied the payment of additional search fees.

Form PCT/ISA/210 (continuation of first sheet (2)) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002306445 A

**Non-patent literature cited in the description**

- *Radiology,* 1994, vol. 192, 555-561